(19) Europäisches Patentamt / European Patent Office / Office européen des brevets

(11) **EP 3 745 431 B1**

(12) **FASCICULE DE BREVET EUROPEEN**

(45) Date de publication et mention
de la délivrance du brevet:
**19.07.2023 Bulletin 2023/29**

(21) Numéro de dépôt: **20172485.3**

(22) Date de dépôt: **30.04.2020**

(51) Classification Internationale des Brevets (IPC):
**H01F 17/06** *(2006.01)* **H02M 1/44** *(2007.01)*

(52) Classification Coopérative des Brevets (CPC):
**H01F 17/062;** H02M 5/458

(54) **DISPOSITIF DE FILTRAGE INDUCTIF ET ARCHITECTURE ÉLECTRIQUE METTANT EN OEUVRE LE DISPOSITIF DE FILTRAGE**

INDUKTIVE FILTERVORRICHTUNG UND ELEKTRISCHE ARCHITEKTUR ZUR UMSETZUNG DIESER FILTERVORRICHTUNG

DEVICE FOR INDUCTIVE FILTERING AND ELECTRIC ARCHITECTURE IMPLEMENTING THE FILTERING DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.05.2019 FR 1904575**

(43) Date de publication de la demande:
**02.12.2020 Bulletin 2020/49**

(73) Titulaire: **THALES**
**92400 Courbevoie (FR)**

(72) Inventeurs:
- **DUBOIS, Eric Ravindranath**
**78400 CHATOU (FR)**
- **KHERBOUCHI, Hocine**
**78400 CHATOU (FR)**
- **LACAUX, Frédéric**
**78400 CHATOU (FR)**
- **ANDRADE, Damian**
**78400 CHATOU (FR)**
- **GUGUEN, Frédéric**
**78400 CHATOU (FR)**

(74) Mandataire: **Atout PI Laplace**
**Immeuble "Visium"**
**22, avenue Aristide Briand**
**94117 Arcueil Cedex (FR)**

(56) Documents cités:
WO-A1-2007/113312 JP-A- H07 153 613
US-A- 4 160 966 US-A1- 2006 125 586
US-A1- 2008 037 298

## Description

L'invention concerne un dispositif de filtrage inductif. Ce type de filtrage est communément utilisé afin de réduire d'éventuelles perturbations présentes sur un conducteur électrique. Le dispositif est alors placé en série sur le conducteur.

L'invention concerne également une architecture électrique mettant en oeuvre le dispositif de filtrage. L'invention est bien adaptée à un réseau électrique embarqué à bord d'un véhicule. L'invention trouve une utilité particulière dans le domaine aéronautique où la tendance actuelle est d'augmenter le nombre d'équipements électriques et donc la puissance électrique embarquée.

Un avion comprend généralement un grand nombre de charges électriques alimentées en puissance électrique par un réseau de fourniture électrique de bord. Par exemple, les commandes de vols de l'avion, les systèmes de climatisation et d'éclairage interne mettent en oeuvre des machines électriques alternatives triphasées. L'énergie électrique fournie à ces machines provient de convertisseurs de puissance reliés à un réseau de bord délivrant de l'énergie électrique sous forme continue ou alternative. Le réseau de bord peut comprendre par exemple des générateurs électriques, des batteries de stockage, ou encore des moyens de liaison à un réseau d'alimentation électrique externe à l'avion et permettant l'alimentation électrique de l'avion lorsqu'il est stationné dans un aéroport. De façon courante à bord d'avion, on trouve des réseaux continus 540V et/ou des réseaux alternatifs 115V ou 230V 400Hz. De manière connue, les convertisseurs de puissance reçoivent de l'énergie du réseau de bord pour la convertir en énergie alternative polyphasée adaptée aux exigences en puissance et en fréquence de la charge. Lorsqu'un convertisseur est alimenté par un réseau alternatif, le convertisseur comprend par exemple un redresseur délivrant une tension continue suivi d'un onduleur produisant la tension alternative nécessaire à la charge à partir de la tension continue. Lorsqu'un convertisseur est alimenté par un réseau continu, le convertisseur comprend alors un circuit remplissant la fonction d'onduleur et produisant la tension alternative directement à partir de la tension continue du réseau de bord. Un convertisseur peut être dédié à une charge ou commun à plusieurs charges.

Dans de nombreux véhicules et plus particulièrement pour les avions, la réduction de masse embarquée est un problème récurrent qui se pose. On a par exemple tenté de mutualiser les convertisseurs. Cette mutualisation est par exemple décrite dans la demande de brevet WO2007/113312 déposée au nom de la demanderesse. Dans ce document, un même convertisseur peut être utilisé pour alimenter différentes charges. Un système d'aiguillage permet d'affecter un ou plusieurs convertisseurs à une charge ou à une autre en fonction du besoin instantané en puissance des différentes charges.

Il est envisagé de combiner en parallèle plusieurs convertisseurs permettant de fournir le niveau de puissance nécessaire à une charge. La mise en parallèle de convertisseurs par une allocation en temps réel pilotée par un organe de commande, à la pluralité de charges, permet d'optimiser la puissance de conversion embarquée et donc de limiter le poids et le coût des éléments de conversion.

La mise en oeuvre d'un dispositif d'alimentation électrique modulaire et reconfigurable repose donc sur la capacité à paralléliser et entrelacer plusieurs convertisseurs de manière dynamique. La mise en parallèle et/ou l'entrelaçage se heurte pourtant à des difficultés liées notamment à la génération de courants de recirculation entre les convertisseurs. Ces courants de recirculation augmentent significativement le courant total vu par les composants actifs des convertisseurs. Pour s'affranchir des difficultés posées par la génération de courants de recirculation, une solution envisagée consiste à mettre en oeuvre entre les convertisseurs associés en parallèle des inductances de couplage également appelées inductance d'interphase. Ce type de composant impose un poids et un volume important pour supporter sans saturation des courants de recirculation élevés. De plus, ce type de composant fige le nombre de convertisseurs raccordés en parallèles. Il est alors difficile de faire varier en temps réel le nombre de convertisseurs que l'on souhaite raccorder en parallèle.

La demande de brevet EP 2 887 519, également déposée au nom de la demanderesse propose de remplacer ces composants communs à plusieurs convertisseurs par des filtres de mode commun distribués dans chacun des convertisseurs. Plus précisément, en entrée ou en sortie de chaque onduleur, des inductances de mode commun sont disposés sur les phases de chaque onduleur, les inductances de chaque onduleur étant indépendantes. Ces inductances permettent à la fois d'entrelacer plusieurs onduleurs et de réduire les perturbations de mode commun. Cette solution de composants distribués permet de retrouver une évolution possible du nombre de convertisseurs associés en parallèle. Il est essentiel d'éviter la saturation des inductances ce qui impose de fortes sections de noyaux magnétiques entraînant un poids important des inductances.

Une autre contrainte est également à prendre en compte dans une architecture électrique. Celle-ci doit être robuste vis-à-vis d'interférences électromagnétiques qu'elle pourrait subir de l'extérieur. L'architecture doit également limiter ses émissions d'interférences. Cette contrainte est généralement appelée « compatibilité électromagnétique » et est généralement traitée au moyen de filtres passifs.

Les caractéristiques des filtres utilisés pour répondre à la contrainte de compatibilité électromagnétique sont bien éloignées de celles des filtres de mode commun que propose d'utiliser la demande de brevet EP 2 887 519 pour limiter les courants de recirculation lorsque plusieurs onduleurs sont raccordés en parallèle. Dans une architecture électrique à convertisseurs raccordés en parallèle, il est donc nécessaire de prévoir deux types de filtre distincts, un pour respecter la contrainte de compatibilité électromagnétique et l'autre pour limiter les courants de recirculation entre convertisseurs.

L'invention propose un nouveau type de filtre permettant à la fois de réduire les courants de recirculation et de répondre à la contrainte de compatibilité électromagnétique. Le dispositif de filtrage selon l'invention est par exemple utilisable en filtre de mode commun implanté dans un convertisseur.

A cet effet, l'invention a pour objet un dispositif de filtrage inductif comprenant plusieurs conducteurs électriques groupés dans un même enroulement et destinés chacun à porter une tension électrique différente et au moins deux noyaux magnétiques toriques chacun formé autour d'un évidement central les deux noyaux magnétiques ayant des longueurs magnétiques différentes, les conducteurs électriques étant enroulé ensemble autour des deux noyaux magnétiques en traversant les évidements centraux des deux noyaux magnétiques, l'enroulement étant formé de plusieurs spires, chaque spire de l'enroulement étant réalisée en enroulant simultanément lesdits plusieurs conducteurs électriques (34a, 34b; 47a, 47b, 47c; 57a, 57b), dans lequel les noyaux magnétiques toriques sont formés dans des matériaux différents, le matériau du noyau magnétique ayant la plus petite longueur magnétique possédant une perméabilité magnétique maximum relative inférieure ou égale à 3000 et plus faible que celle du matériau du noyau magnétique ayant la plus grande longueur magnétique.

Pour de nombreux fabricant, la mesure de la perméabilité magnétique de valeur « faible » se fait pour une excitation magnétique de 100 mA/cm à une fréquence de 10k Hz. La valeur de 3000 est considérée comme « faible ». Pour des mesures réalisée dans ces conditions, on peut accepter une tolérance de +/-15%. Plus précisément, lorsqu'un fabricant donne une valeur nominale de 3000, la valeur réelle de perméabilité magnétique relative peut varier de 2550 à 3450. On considère que tous les circuits magnétiques donnés pour une valeur nominale de 3000 et ayant une valeur réelle de 3450 respectent la condition énoncée.

Avantageusement, les conducteurs électriques forment ensemble au moins une spire enroulée autour des deux noyaux magnétiques et au moins une autre spire enroulée autour du noyau magnétique ayant la plus petite longueur magnétique sans être enroulée autour de l'autre des deux noyaux magnétiques.

Avantageusement, chacun des évidements centraux s'étend selon un axe, les axes étant confondus.

Chacun des évidements centraux possède une section vide perpendiculaire à leur axe respectif. Dans une première variante de l'invention, les sections des différents évidements centraux sont avantageusement identiques.

Dans une deuxième variante de l'invention, un des deux noyaux magnétiques est disposé à l'intérieur de l'évidement central de l'autre noyau magnétique.

Les deux noyaux magnétiques peuvent former un ensemble monobloc.

Dans une troisième variante de l'invention, le dispositif de filtrage comprend plusieurs séries de noyaux magnétiques toriques insérés les uns dans les autres, les noyaux magnétiques d'une première des séries étant imbriquée autour d'un premier axe, les noyaux magnétiques d'une seconde des séries étant imbriquée autour d'un second axe, le premier axe étant distinct du second axe. Le conducteur électrique forme un premier enroulement autour de la première des séries et forme un second enroulement autour de la seconde des séries.

Dans une quatrième variante de l'invention, le conducteur électrique forme enroulement complémentaire réalisé autour des noyaux magnétiques sans traverser leur évidement central.

Les noyaux magnétiques peuvent posséder des formes tubulaires régulières ou irrégulières.

Avantageusement, le noyau magnétique ayant la plus petite longueur magnétique comprend au moins une rainure configurée pour augmenter la réluctance du noyau magnétique considéré sur toute la hauteur de l'évidement central, hauteur définie selon un axe autour duquel l'évidement central se développe.

La rainure peut être configurée pour faire varier la réluctance du noyau magnétique considéré selon une abscisse portée par l'axe autour duquel l'évidement central se développe.

La rainure peut être configurée pour faire baisser la réluctance du noyau magnétique considéré en s'éloignant de l'axe autour duquel l'évidement central se développe.

L'invention a également pour objet une architecture électrique comprenant plusieurs convertisseurs susceptibles d'alimenter en parallèle une charge, chacun des convertisseurs comprenant au moins un dispositif de filtrage selon l'une des revendications précédentes.

Avantageusement, les convertisseurs reçoivent de l'énergie sous forme d'un courant continu et délivrent de l'énergie sous forme de courants alternatifs multiphasés,
dans laquelle chaque convertisseur comprend, en entrée, un dispositif de filtrage inductif selon l'invention dans lequel le courant continu circule dans les conducteurs enroulés ensemble,

- dans laquelle chaque convertisseur comprend, en sortie, un dispositif de filtrage inductif selon l'invention dans lequel les courants alternatifs circulent dans les conducteurs enroulés ensemble.

L'invention sera mieux comprise et d'autres avantages apparaîtront à la lecture de la description détaillée d'un mode de réalisation donné à titre d'exemple, description illustrée par le dessin joint dans lequel :

les figures 1a et 1b représentent deux noyaux magnétiques de dimensions différentes ;

la figure 2 représente une première variante de dispositif de filtrage inductif selon l'invention mettant en oeuvre les noyaux magnétiques représentés sur les figures 1a et 1b ;

la figure 3 représente une deuxième variante de dispositif de filtrage inductif selon l'invention mettant en oeuvre plusieurs noyaux magnétiques toriques insérés les uns dans les autres ;

la figure 4 représente une troisième variante de dispositif de filtrage inductif selon l'invention mettant en oeuvre plusieurs séries de noyaux magnétiques toriques insérés les uns dans les autres ;

la figure 5 représente une quatrième variante dispositif de filtrage inductif selon l'invention mettant en oeuvre plusieurs noyaux magnétiques toriques insérés les uns dans les autres ;

les figures 6 et 7 représentent deux exemples d'une cinquième variante de dispositif de filtrage inductif selon l'invention mettant en oeuvre plusieurs noyaux magnétiques superposés ;

la figure 8 représente une sixième variante de dispositif de filtrage inductif selon l'invention mettant en oeuvre plusieurs noyaux magnétiques toriques superposés les uns sur les autres ;

la figure 9 représente un noyau magnétique pouvant être mis en oeuvre dans un dispositif de filtrage inductif selon l'invention ;

la figure 10 représente une septième variante de dispositif de filtrage inductif selon l'invention mettant en oeuvre plusieurs séries de noyaux magnétiques toriques insérés les uns dans les autres ;

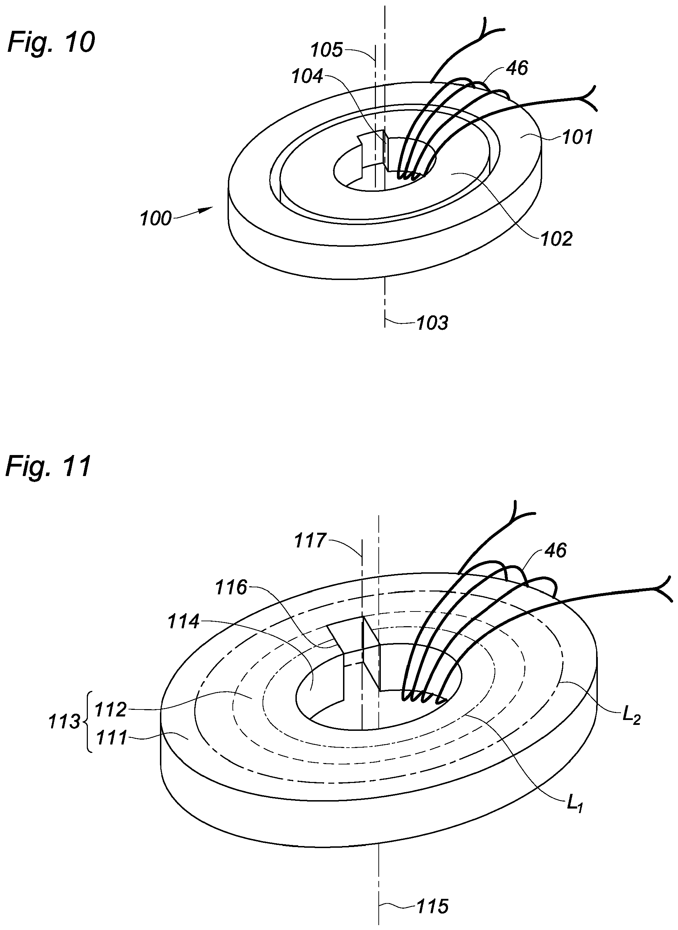

le figure 11 représente une huitième variante de dispositif de filtrage selon l'invention mettant en oeuvre un noyau magnétique monobloc ;

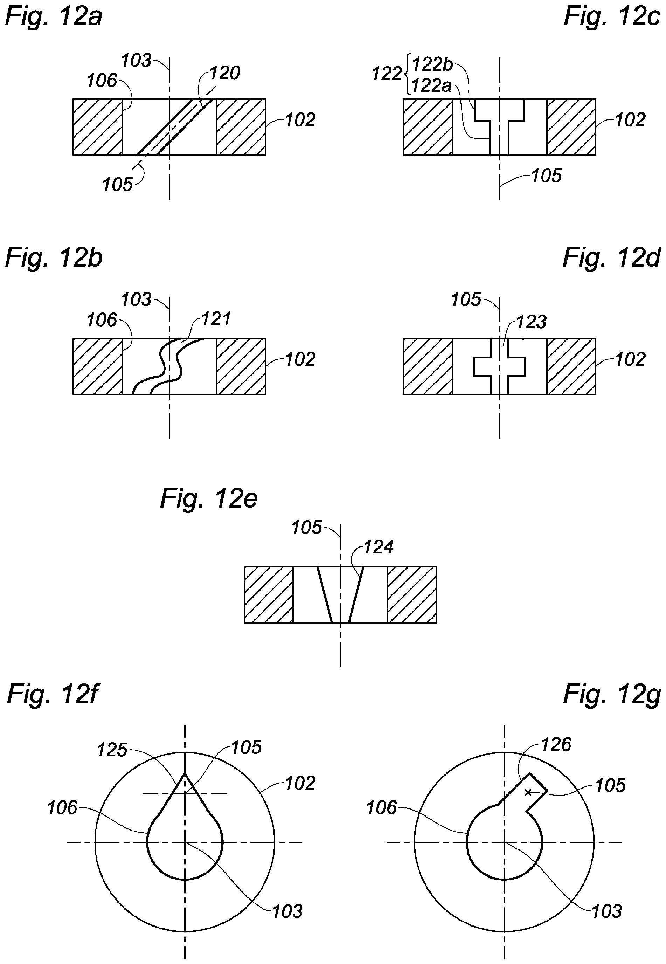

les figures 12a à 12g représentent plusieurs variantes de noyaux magnétiques comprenant chacun une rainure de forme différente ;

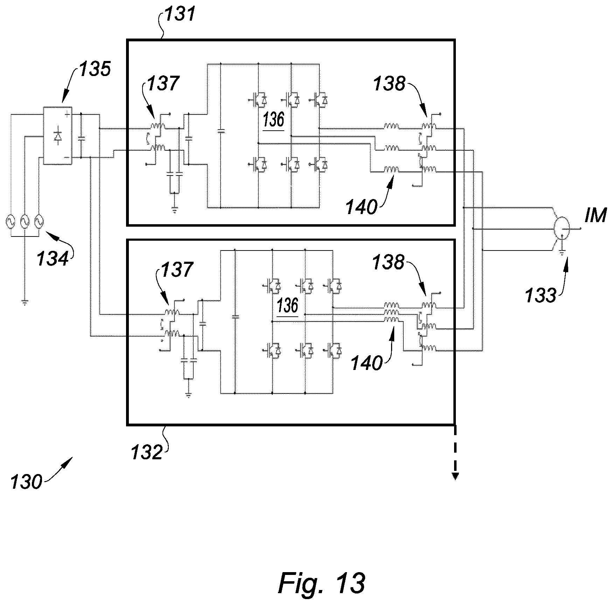

La figure 13 représente une architecture électrique mettant en oeuvre plusieurs dispositifs de filtrage selon l'invention.

Par souci de clarté, les mêmes éléments porteront les mêmes repères dans les différentes figures.

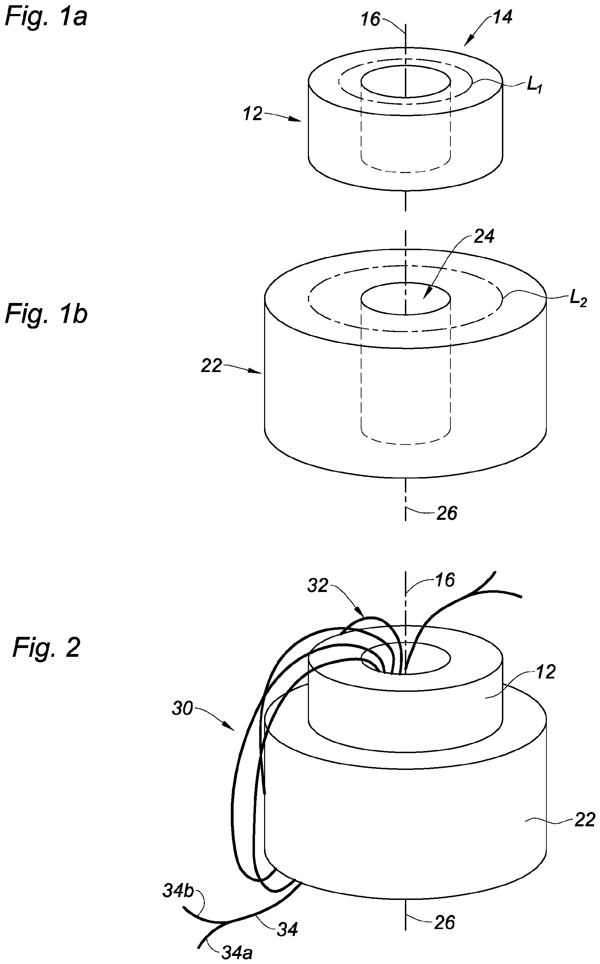

La figure 1a représente un noyau magnétique torique 12 formé autour d'un évidement central 14. Le noyau magnétique est de forme tubulaire s'étendant autour d'un axe 16. L'évidement central se développe autour de l'axe 16. De façon géométrique, le noyau magnétique 12 peut être caractérisé par sa longueur magnétique $L_1$. De façon générale, la longueur magnétique est la longueur moyenne des lignes de champ magnétique circulant dans le noyau magnétique. Lorsqu'une bobine est enroulée autour d'un noyau magnétique torique en traversant l'évidement central, et lorsque le noyau magnétique est réalisé dans un matériau homogène, la longueur magnétique est sensiblement la longueur des fibres moyennes entourant l'évidement central. Plus précisément la longueur des fibres moyennes est la longueur d'un axe formé par le centre des sections du noyau magnétique dans des plans contenant l'axe 16 autour duquel se développe l'évidement central. Dans l'exemple représenté sur la figure 1a, l'évidement central 14 possède une section circulaire perpendiculairement à l'axe 16 et la longueur magnétique $L_1$ est le périmètre d'un cercle. De façon générale, la longueur magnétique L est utilisée pour appliquer de façon macroscopique la loi d'Ampère :

$$HL = n.i \qquad (1)$$

H représente l'excitation magnétique avant saturation et i représente le courant circulant dans n spires enroulées autour du noyau magnétique.
La figure 1b représente un second noyau magnétique torique 22 formé autour d'un évidement central 24. Le second noyau magnétique 22 est de forme tubulaire s'étendant autour d'un axe 26. L'évidement central 24 s'étend selon l'axe 26. La longueur magnétique $L_2$ du second noyau magnétique torique 22 est supérieure à la longueur magnétique $L_1$ du premier noyau magnétique 12.
Les deux noyaux magnétiques 12 et 22 sont des noyaux magnétiques fermés sans entrefer. Ce type de noyau est habituellement appelé « torique » chez de nombreux fabricants. Ce qualificatif va bien au-delà de la forme d'un tore telle que définie mathématiquement. On trouve notamment des noyaux magnétiques dits toriques à section circulaire, rectangulaire...
La figure 2 représente une première variante de dispositif de filtrage 30 comprenant les deux noyaux magnétiques toriques 12 et 22. Dans l'exemple représenté, les deux noyaux 12 et 22 possèdent des diamètres extérieurs différents. Le diamètre extérieur du premier noyau magnétique 12 autour de l'axe 16 est supérieur au diamètre de l'évidement central 24 autour de l'axe 26. Les deux noyaux 12 et 22 sont distincts et superposés de façon à faire coïncider les axes 16 et 26. Un enroulement 32 de plusieurs spires d'un groupe de conducteurs électriques 34 est réalisé autour de l'empilement des deux noyaux magnétiques 12 et 22 en traversant les deux évidements centraux 14 et 24. Ainsi chacun des deux noyaux magnétiques 12 et 22 reçoit une excitation magnétique générée par les courants circulant dans le groupe de conducteurs électriques 34. Dans l'exemple représenté sur la figure 2, le groupe 34 comprend deux conducteurs électriques 34a et 34b enroulés ensemble autour des deux noyaux magnétiques 12 et 22. Les deux conducteurs électriques 34a et 34b peuvent être regroupés au sein d'un câble ou rester séparés. Les deux conducteurs 34a et 34b sont isolés électriquement l'un de l'autre. Chaque spire de l'enroulement est réalisée en enroulant simultanément les deux conducteurs électriques 34a et 34b. Classiquement, lorsque deux conducteurs électriques isolés sont enroulés autour d'un noyau magnétique, les deux conducteurs 34a et 34b forment chacun des enroulements séparés. Ici, au contraire, un des conducteurs a pour voisin immédiat l'autre conducteur dans chaque spire et tout au long de l'enroulement.

Les deux conducteurs 34a et 34b sont destinés à porter des tensions électriques différentes, par exemple la tension positive et la tension négative de la sortie d'une alimentation en courant continue ou la phase et le neutre d'une alimentation alternative monophasée. Il est également possible de prévoir plus de deux conducteurs électriques groupés, par exemple pour filtrer les différentes phases de sortie d'une alimentation alternative polyphasée.

Les conducteurs électriques génèrent chacun une excitation magnétique dans les noyaux magnétiques 12 et 22. En enroulant les conducteurs séparément, chacun dans un enroulement distinct, même avec un courant opposé et de même valeur dans chacun des conducteurs, une excitation différentielle peut être généré dans les noyaux magnétiques 12 et 22 du fait de l'écart de géométrie des différents enroulements. La différence d'excitation peut être de l'ordre de 1 à 2%. En revanche, en enroulant les conducteurs électriques ensemble dans le même enroulement, la différence d'excitation peut rester en-dessous de 0,1%. Le fait que les conducteurs électriques soient enroulés ensemble permet de filtrer plus efficacement les courants de mode commun pouvant circuler sur les différents conducteurs sans être gêné par des courants différentiels risquant de saturer les noyaux magnétiques.

Les diamètres des évidements centraux 14 et 24 sont avantageusement identiques. Les évidements centraux 14 et 24 sont disposés dans le prolongement l'un de l'autre afin de faciliter l'enroulement des spires, notamment lors de la traversée des évidements centraux 14 et 24 par des spires. Sur la figure 2, quatre spires sont représentées. Il est bien entendu que dans la pratique, il est possible d'enrouler un plus grand nombre de spires, pouvant dépasser le millier de spires. Par ailleurs, il est possible d'enrouler autour des noyaux magnétiques 12 et 22 plusieurs conducteurs électriques indépendants. Ceci est notamment utile lorsque le dispositif de filtrage est utilisé dans un réseau polyphasé, chaque phase transitant par un des conducteurs. Dans cette première variante, il est possible d'empiler plus de deux noyaux magnétiques.

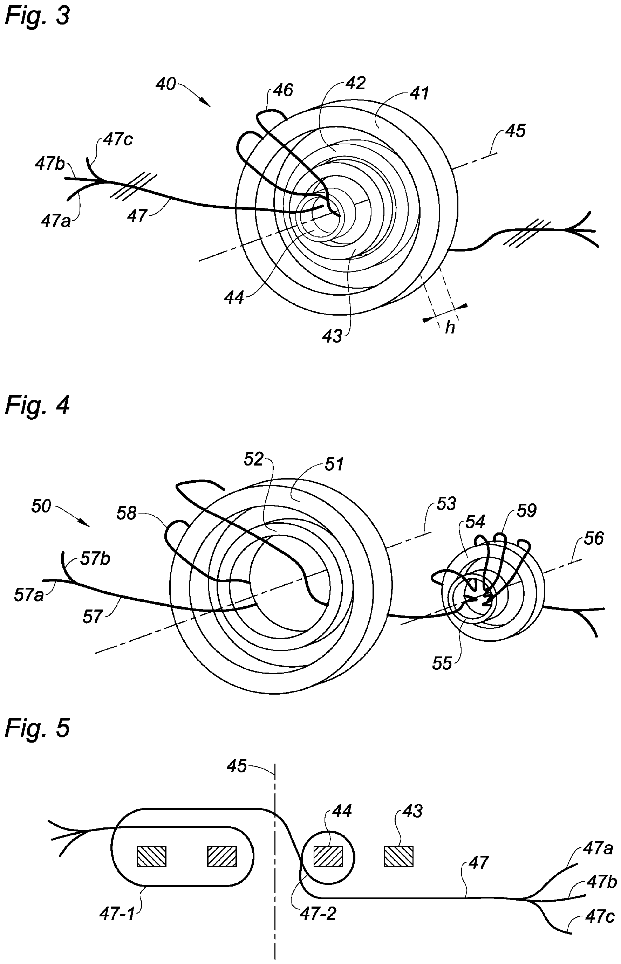

La figure 3 représente seconde variante de dispositif de filtrage 40 dans lequel plusieurs noyaux magnétiques toriques distincts sont insérés les uns dans les autres. Plus précisément, avec deux noyaux magnétiques, le diamètre de l'évidement central du premier noyau magnétique est plus grand que le diamètre extérieur du second noyau magnétique. Ainsi le second noyau magnétique peut être inséré dans l'évidement central du premier noyau magnétique. Il est possible de mettre en oeuvre l'invention quelque-soit le nombre de noyaux magnétiques insérés les uns dans les autres. Dans la variante représentée sur la figure 3, quatre noyaux magnétiques toriques 41, 42, 43 et 44 sont insérés les uns dans les autres. Plus précisément, le noyau 44, le plus au centre est inséré dans l'évidement central du noyau 43 qui est lui-même inséré dans l'évidement central du noyau 42 qui à son tour est inséré dans l'évidement central du noyau 41. Les longueurs magnétiques des différents noyaux sont toutes différentes. La plus grande longueur magnétique est celle du noyau 41 et la plus petite, celle du noyau 44.

Afin d'optimiser le volume occupé par le dispositif de filtrage 40 les axes évidements centraux des différents noyaux magnétiques 41 à 44 sont avantageusement confondus. Sur la figure 3 ces axes confondus portent le repère 45. Cela permet d'occuper au maximum l'évidement central du noyau magnétique 41. Plus précisément, au jeu fonctionnel près, le diamètre de l'évidement central du noyau magnétique 41 est égal diamètre extérieur du noyau magnétique 42 et ainsi de suite jusqu'au noyau magnétique 44 dont le diamètre extérieur est égal au diamètre de l'évidement central du noyau magnétique 43. Les diamètres des noyaux magnétiques sont définis autour de leur axe 45.

Toujours pour optimiser le volume occupé par le dispositif de filtrage 40, les hauteurs h des différents noyaux magnétiques définies le long de leur axe 45 sont toutes avantageusement égales.

Un enroulement 46 de plusieurs spires d'un groupe de conducteurs électriques 47 est réalisé autour des quatre noyaux magnétiques 41 à 44 en traversant l'évidement central du noyau magnétique 44. Dans l'exemple représenté, trois conducteurs électriques 47a, 47b et 47c forment le groupe 47. Les trois conducteurs sont enroulés ensemble autour des quatre noyaux magnétiques 41 à 44. Ainsi chacun des quatre noyaux magnétiques 41 à 44 reçoit une excitation magnétique générée par le courant circulant dans le groupe de conducteurs électriques 47.

Pour chacun des dispositifs de filtrage 30 et 40 décrits à l'aide des figures 2 et 3 les noyaux qui le composent reçoivent tous la même force magnétomotrice correspondant au courant circulant dans l'enroulement multiplié par le nombre de spires de l'enroulement (n.i). L'excitation magnétique H diffère d'un noyau à l'autre en fonction de la longueur magnétique du noyau considéré. Plus précisément, l'excitation magnétique est d'autant plus forte que le diamètre du noyau est petit. Par exemple, dans le dispositif de filtrage 40 l'excitation magnétique du noyau 44 est plus forte que celle du noyau 43 et ainsi de suite jusqu'à la plus faible excitation magnétique du noyau 41.

Dans un dispositif de filtrage, les différents noyaux magnétiques peuvent être réalisés dans un même matériau. Ainsi pour une même fréquence, lorsque le courant circulant dans l'enroulement augmente, le noyau ayant la plus petite longueur magnétique atteindra plus rapidement son excitation de saturation. Alternativement, les différents noyaux magnétiques peuvent être réalisés dans des matériaux différents, notamment des matériaux ayant des perméabilités magnétiques différentes. Comme précédemment, il est possible, pour un courant donné de saturer l'un des noyaux magnétique tout en restant en deçà de la saturation pour un autre noyau magnétique. Tant que le courant circulant dans l'enroulement ne permet d'atteindre la saturation d'aucun des circuits magnétiques, la valeur de self du filtre conserve une valeur nominale élevée. Lorsque le courant permet de saturer l'un des noyaux, la valeur de self du filtre est inférieure à la valeur nominale mais peut conserver une valeur utile permettant au filtre de remplir sa fonction ou tout au moins une partie de ses fonctions.

Alternativement, il est possible de choisir les perméabilités magnétiques et les dimensions des noyaux imbriqués de façon à obtenir, pour une même valeur de courant circulant dans l'enroulement, la saturation de tous les noyaux magnétiques. Pour obtenir cette même excitation de saturation, en plus du choix de la perméabilité magnétique des différents noyaux, il est également possible d'adapter les dimensions des différents noyaux magnétiques afin de modifier la longueur magnétique des différents noyaux magnétiques. En pratique, pour le noyau magnétique ayant la plus petite longueur magnétique, par exemple le noyau magnétique 12 dans le cas du filtre 30 de la figure 2, on peut choisir une perméabilité magnétique relative $\mu_r$ plus faible que celle du noyau magnétique ayant la plus grande longueur magnétique, en l'occurrence, le noyau magnétique 22 du filtre 30.

En première approche, un filtre possédant plusieurs noyaux magnétiques de perméabilité différente, peut être équivalent à un filtre ne possédant qu'un seul noyau magnétique possédant une perméabilité équivalente dont la valeur est située entre les valeurs extrêmes des différents noyaux magnétiques du filtre. Cette équivalence peut être admise lorsque les différents noyaux magnétiques atteignent leur saturation pour le même courant, mais également pour des courants différents et plus précisément tant que le courant circulant dans l'enroulement reste inférieur au plus faible des courants pour lequel un des noyaux magnétique atteint sa saturation.

En pratique, la perméabilité magnétique d'un noyau est fonction du matériau utilisé pour le réaliser. Les fabricants de noyaux proposent dans leur catalogue, différentes valeurs discrètes de perméabilité magnétique. Cependant, les valeurs intermédiaires ne sont pas directement disponibles sauf à réaliser des commandes spéciales hors catalogue. En mettant en oeuvre l'invention, il est possible d'atteindre ces valeurs intermédiaires au moyen de composants standards déjà proposés par les fabricants.

De plus, lors de l'utilisation de ce type de dispositif de filtrage où les perméabilités magnétiques des différents noyaux sont différentes le comportement du filtre en fonction de la fréquence du courant qui circule dans l'enroulement peut être différent du comportement d'un filtre à noyau unique réalisé dans un matériau possédant une perméabilité équivalente.

En choisissant, pour le noyau magnétique ayant la plus petite longueur magnétique, noyau 12 pour la figure 2 ou noyau 44 pour la figure 3, une valeur de perméabilité magnétique relative inférieure à 3000, ce noyau n'atteindra sa saturation que pour des courants très importants. Cela permet de filtrer des courants de recirculation importants entre plusieurs convertisseurs. La perméabilité magnétique, souvent notée $\mu_r$ des matériaux mis en oeuvre dans les noyaux magnétiques est donnée relativement par rapport à la perméabilité du vide souvent notée $\mu_0$. En théorie, la perméabilité magnétique relative d'un matériau dépend du courant circulant dans l'enroulement disposé autour du noyau et baisse lorsque le noyau se sature. Les fabricants de matériau magnétique annonce la perméabilité magnétique relative maximum, c'est-à-dire loin de la saturation dans le domaine linéaire reliant champ magnétique et le champ d'excitation magnétique. C'est cette valeur qui est retenue pour définir la perméabilité magnétique des noyaux magnétiques. La figure 4 représente une troisième variante de dispositif de filtrage 50 selon l'invention mettant en oeuvre plusieurs séries de noyaux magnétiques toriques insérés les uns dans les autres. Le dispositif de filtrage 50, représenté sur le figure 4, comprend une première série formée de deux noyaux magnétiques 51 et 52 imbriqués l'un dans l'autre autour d'un axe 53 et une seconde série formée de deux noyaux magnétiques 54 et 55 également imbriqués l'un dans l'autre mais autour d'un second axe 56 distinct de l'axe 53. Cette variante peut être mise en oeuvre quelque-soit le nombre de séries et quelque-soit le nombre de noyaux magnétiques par série. Dans la pratique, pour la réalisation d'un dispositif de filtrage selon cette variante, on dispose d'une grande liberté dans le positionnement relatif des axes 53 et 56 qui peuvent même être disposés dans le prolongement l'un de l'autre.

Un groupe de conducteurs électriques 57 comprend, dans l'exemple représenté, deux conducteurs électriques 57a et 57b. Le groupe 57 forme un premier enroulement 58 de n1 spires autour des noyaux magnétiques 51 et 52 en traversant l'évidement central du noyau magnétique 52 et forme un second enroulement 59 de n2 spires autour des noyaux magnétiques 54 et 55 en traversant l'évidement central du noyau magnétique 55. Les conducteurs électriques 57a et 57b sont enroulés ensemble pour former les n1 et n2 spires. Un intérêt de cette variante est de permettre la réalisation d'un dispositif de filtrage dont les nombres de spires n1 et n2 sont différents. Ceci permet d'appliquer à chaque série de noyaux magnétiques des forces magnétomotrices (n.i) différentes. Cette variante présente un intérêt particulier en réalisant un plus grand nombre de spires autour du noyau magnétique ayant la plus faible perméabilité magnétique. Autrement dit, cela permet d'augmenter l'inductance du dispositif de filtrage du fait de l'augmentation du nombre de spires sans dégrader la saturation du ou des noyaux magnétiques à forte perméabilité magnétique.

La figure 5 représente un exemple d'une quatrième variante de dispositif de filtrage dans lequel on retrouve les noyaux magnétiques 43 et 44 insérés l'un dans l'autre comme sur la figure 3. Le noyau magnétique 44 est le plus petit et sa perméabilité magnétique est plus faible que celle du noyau magnétique 45. Les conducteurs électriques du groupe 47 forment ensemble une première spire 47-1 enroulée autour des deux noyaux magnétiques 43 et 44 et une seconde spire 47-2 enroulée uniquement autour du noyau magnétique 44. Autrement dit, deux spires entourent le noyau magnétique 44 et une seule spire entoure le noyau magnétique 43. Les deux spires 47-1 et 47-2 sont enroulées dans le même sens. Il est bien entendu que le nombre de spires entourant chacun des noyaux magnétiques 43 et 44 peut être adapté en fonction du besoin. De plus, il est possible d'ajouter d'autres noyaux magnétiques par exemple comme représenté sur la figure 3. L'avantage de la variante représentée sur la figure 5 est de combiner l'avantage de compacité de la variante de la figure 3 et l'adaptation du nombre de spires à la perméabilité magnétique des différents noyaux magnétiques présents comme illustré à l'aide de la figure 4.

De façon plus générale, les conducteurs électriques forment ensemble au moins une spire enroulée autour du noyau magnétique 44 ayant la plus petite longueur magnétique $L_1$ et au moins une autre spire enroulée autour de plusieurs des différents noyaux magnétiques appartenant au filtre inductif.

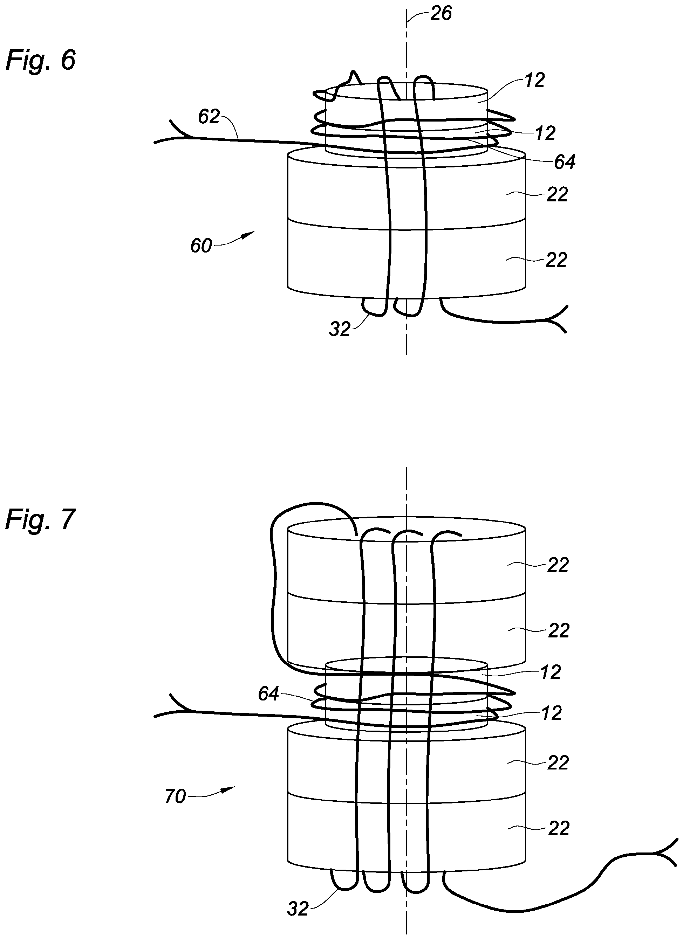

La figure 6 représente un exemple d'une cinquième variante de dispositif de filtrage 60 selon l'invention mettant en oeuvre plusieurs noyaux magnétiques de diamètre extérieur différents et superposés les uns sur les autres comme dans la variante de la figure 2. Pour ne pas alourdir la description, on reprendra les repères 12 et 22 déjà utilisés. Le dispositif de filtrage 60 comprend un empilement de deux noyaux magnétiques 22 et deux noyaux magnétiques 12 empilés les uns sur les autres selon l'axe 26. Cette variante peut être mise en oeuvre quelque-soit le nombre de noyaux magnétiques empilés les uns sur les autres.

Un groupe de conducteurs électriques 62 forme l'enroulement 32 traversant les évidements centraux des noyaux magnétiques 12 et 22 et un enroulement complémentaire 64 réalisé autour des noyaux magnétiques 12 sans traverser leur évidement central. Comme précédemment, les différents conducteurs électriques du groupe 62 sont enroulés ensemble pour former les enroulements 32 et 64.

L'enroulement complémentaire 64 permet d'obtenir, pour les noyaux magnétiques 12 une force magnétomotrice supérieure à celle reçue par les noyaux magnétiques 22. Afin de réduire le volume occupé par le dispositif de filtrage 60, l'enroulement complémentaire 64 est avantageusement réalisé autour du noyau magnétique ayant le plus petit diamètre extérieur, en l'occurrence le noyau 12. Afin d'optimiser le rangement des enroulements 32 et 64, l'enroulement 32 recouvre l'enroulement complémentaire 64.

La figure 7 représente un autre exemple 70 de la cinquième variante de dispositif de filtrage dans lequel on retrouve des noyaux magnétiques 12 et 22. Dans cet exemple, deux noyaux magnétiques 12 sont disposés entre deux paires de noyaux magnétiques 22. Comme précédemment, l'enroulement complémentaire 64 est réalisé autour des deux noyaux magnétiques 12.

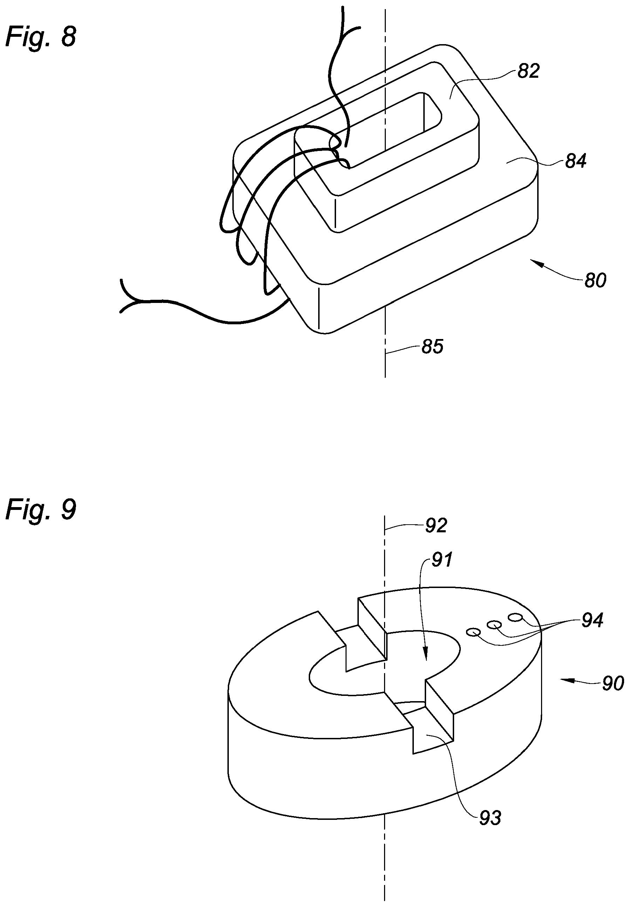

la figure 8 représente une sixième variante de dispositif de filtrage 80 mettant en oeuvre deux noyaux magnétiques toriques 82 et 84 superposés l'un sur l'autre. La disposition des noyaux magnétiques 82 et 84 du dispositif de filtrage 80 est voisine de la disposition des noyaux magnétiques 12 et 22 du dispositif de filtrage 20 de la figure 2.

Les deux noyaux magnétiques 82 et 84 possèdent des sections extérieures sensiblement rectangulaires et des évidements centraux également de section sensiblement rectangulaires. Comme dans la figure 2, les noyaux magnétiques 82 et 84 sont de forme tubulaire s'étendant autour du même axe 85. Les sections rectangulaires sont définies perpendiculairement à l'axe 85. Les sections des évidements centraux des deux noyaux magnétiques 82 et 84 peuvent être identiques. Par contre la section extérieure du noyau magnétique 82 est plus petite que celle du noyau magnétique 84. Ainsi comme précédemment les longueurs magnétiques des deux noyaux magnétiques 82 et 84 sont différentes.

En pratique, il est possible de mettre en oeuvre l'invention quelle que soit la forme de la section des évidements centraux.

Dans les différentes variantes décrites précédemment, les noyaux magnétiques possèdent des formes tubulaires régulières. Alternativement, dans le cadre de l'invention, il est possible de mettre en oeuvre des noyaux magnétiques dont la forme est irrégulière. Ceci permet d'adapter les propriétés magnétiques des noyaux au besoin de filtrage.

La figure 9 un noyau magnétique 90 torique. Plus précisément le noyau magnétique 90 possède un évidement central 91 s'étendant le long d'un axe 92. Le noyau magnétique 90 comprend une rainure 93 s'étendant perpendiculairement à l'axe 92. Le noyau magnétique 90 comprend également des perçages borgnes 94 ou traversant s'étendant parallèlement à l'axe 92. La rainure 93 et les perçages 94 permettent de modifier le comportement magnétique global du noyau magnétique 90 par rapport à un noyau magnétique ne comprenant pas ces irrégularités géométriques. Les irrégularités forment un entrefer partiel entrainant une augmentation de réluctance du noyau magnétique. En pratique, le comportement magnétique du noyau magnétique 90 peut être assimilé au comportement d'un noyau magnétique sans irrégularité géométrique et possédant un matériau de plus faible perméabilité magnétique. Pour un même nombre de spires de l'enroulement traversant l'évidement central 91, la présence d'irrégularités géométriques permet d'augmenter le courant circulant dans l'enroulement pour lequel on obtient la saturation du noyau magnétique. Sur la figure 9, deux types d'irrégularités géométriques sont représentés à titre d'exemple. Il est bien entendu possible de ne mettre en oeuvre qu'un seul type d'irrégularité ou d'autres types d'irrégularités. Il est notamment possible de mettre en oeuvre un procédé de fabrication additive pour réaliser les noyaux magnétiques d'un dispositif de filtrage selon l'invention. Un tel procédé de fabrication permet de réaliser toute forme de zone où le matériau magnétique est absent, notamment des zones complètement noyées, c'est-à-dire sans accès vers la surface extérieure du noyau magnétique. Un noyau magnétique possédant une ou plusieurs irrégularités géométriques peut être mis en oeuvre dans tous les filtres représentés sur les figures 2 à 8. De façon plus générale, un noyau magnétique possède une forme tubulaire régulière lorsque sa section tournant autour de l'axe selon lequel l'évidement central s'étend est constante. Ainsi le flux magnétique circulant dans le noyau magnétique et tournant autour de l'axe de l'évidement central ne subit aucune perturbation du fait de la géométrie du noyau magnétique. Au contraire, la forme tubulaire du noyau magnétique est irrégulière lorsque sa section possède des irrégularités telles que par exemples décrites sur la figure 9. Ces irrégularités formant des entrefers partiels perturbant le flux magnétique circulant dans le noyau magnétique et tournant autour de l'axe de l'évidement central.

La figure 10 représente une variante de dispositif de filtrage 100 possédant deux noyaux magnétiques distincts 101 et 102 insérés l'un dans l'autre comme dans la variante de la figure 3. Le noyau magnétique 102 est disposé dans l'évidement central du noyau magnétique 101. Les axes des évidements centraux des noyaux magnétiques 101 et 102 sont confondus et portent le repère 103. On retrouve l'enroulement 46 entourant les deux noyaux magnétiques 101 et 102 et traversant l'évidement central du noyau magnétique 102. Le noyau magnétique 101 ne possède pas d'irrégularité. A l'inverse, le noyau magnétique 102 possède une rainure 104 s'étendant selon un axe 105 parallèle à l'axe 103. La rainure 104 forme un entrefer partiel dans le noyau magnétique 102 tendant à augmenter la réluctance du noyau magnétique par rapport à un noyau magnétique sans rainure. La rainure 104 s'étend sur toute la hauteur de l'évidement central 106, hauteur définie selon l'axe 103 du noyau magnétique 102.

L'orientation de la rainure 104 permet de mieux optimiser le noyau magnétique 102 que l'orientation de la rainure 93 pour le noyau magnétique 90, notamment en termes de masse pour de mêmes propriétés magnétiques. Plus précisément, les rainures 93 et 104 permettent d'augmenter la réluctance de leur noyau magnétique respectif et de réduire la valeur de perméabilité magnétique équivalente le long de la longueur magnétique L1. La forme de la rainure 104, située tout entière sur une longueur magnétique plus faible que la rainure 93 rend plus efficace sa contribution à l'augmentation de réluctance du noyau magnétique. Il est bien entendu possible de prévoir plusieurs rainures 93 ou 104 dans un même noyau magnétique.

La figure 11 représente une autre variante de dispositif de filtrage 110 possédant deux noyaux magnétiques toriques 111 et 112 assemblés pour former un ensemble monobloc 113 possédant un évidement central 114 s'étendant le long d'un axe 115. Les deux magnétiques toriques 111 et 112 sont concentriques autour de l'axe 115. On retrouve l'enroulement 46 traversant l'évidement central 114. En pratique, l'ensemble monobloc 113 peut être réalisé en une seule pièce mécanique et dans le même matériau. Le noyau 111 est semblable au noyau 101 et ne possède pas d'irrégularité. Le noyau 112 possède une rainure 116 s'étendant selon un axe 117 parallèle à l'axe 115. Il est possible de réaliser les deux noyaux magnétiques toriques 111 et 112 dans deux matériaux différents sertis l'un dans l'autre. Alternativement, il est possible de les réaliser dans le même matériau également sertis l'un dans l'autre ou à partir d'un noyau magnétique unique dans lequel la rainure 116 est réalisée. On retrouve les deux longueurs magnétiques $L_1$ pour le noyau magnétique 112 et $L_2$ pour le noyau magnétique 111. Les lignes de champs se propageant le long de la longueur $L_2$ ne circulent qu'à l'intérieur d'un matériau magnétique, celui du noyau 112, alors que les lignes de champs se propageant le long de la longueur $L_1$ circulent en partie dans le matériau magnétique du noyau 111 ainsi que dans la rainure 116 formant un entrefer.

Les figures 12a à 12g représentent plusieurs variantes de noyaux magnétiques 102 ou 113 comprenant une rainure coupant toute les lignes de champ se développant le long des plus faibles longueurs magnétiques du noyau. Autrement dit, la rainure s'étend sur toute la hauteur de l'évidement central 106, hauteur définie selon l'axe 103. Les figures 12a à 12e représentent le noyau magnétique 102 en coupe par un plan contenant l'axe 103 et les figures 12f et 12g représentent le noyau magnétique 102 en vue de dessus dans un plan perpendiculaire à l'axe 103. Sur la figure 12a, la rainure 120 s'étend de façon oblique par rapport à la direction 103. L'axe 105 de la rainure 120 est incliné par rapport l'axe 103 de l'évidement central 106. L'axe 105 reste tangent à un cylindre d'axe 103. Par rapport à la rainure 104, la rainure 120 permet d'augmenter encore la réluctance du noyau magnétique 102 en augmentant la surface des faces en regard de la rainure 120 par rapport à celle de la rainure 104. Cette augmentation de réluctance peut être obtenue au moyen d'une rainure 121 s'étendant selon une courbe non rectiligne le long de la surface de l'évidement central 106 du noyau magnétique 102, comme représenté sur la figure 12b. Toute courbe permettant d'augmenter la longueur de la rainure 121 par rapport à la longueur de la rainure 104 le long de son axe 105 peut être mise en oeuvre.

Sur la figure 12c, le noyau magnétique 102 comprend une rainure 122 en forme de lettre T. La barre verticale du T s'étend le long de l'axe 105 qui reste parallèle à l'axe 103 et la barre horizontal du T s'étend perpendiculairement à l'axe 105. La rainure 122 comprend une première partie 122a de faible largeur perpendiculairement à l'axe 105. La partie 122a forme la barre verticale du T. La rainure 122 comprend une seconde partie 122b de plus forte largeur et correspondant à la barre horizontale du T. Les deux parties 122a et 122b présentent des réluctances différentes. La réluctance de la partie 122b est plus importante que celle de la partie 122a. En fonctionnement, lorsque le courant de mode commun augmente dans l'enroulement 46 entourant le noyau 102, le noyau magnétique 102, dans sa partie basse dans laquelle la rainure 122 possède sa plus faible largeur peut saturer tout en restant dans son domaine non saturé dans sa partie haute où les lignes de champ croisent la partie 122b de la rainure. En d'autre termes, la rainure 122 permet de réaliser un noyau à réluctance étagée, plus faible en regard de la partie 122a et plus élevée en regard de la partie 122b. D'autres formes de rainures peuvent remplir cette fonction, par exemple la rainure 123 en forme de croix, comme représentée sur la figure 12d. Les rainures 122 et 123 permettent d'obtenir des réluctances à deux étages. Il est possible de d'obtenir un plus grand nombre d'étages au moyen d'une rainure en escalier. Il est également possible de faire varier de façon linéaire la réluctance le long de l'axe 103, par exemple avec une rainure 124 en forme de lettre V comme représentée sur la figure 12e. Autrement dit, la section de la rainure 124 s'évase selon une abscisse portée par l'axe 105. Il est possible de combiner les formes en T, en croix ou en V avec une inclinaison de la rainure telle que représentée sur la figure 12a ou avec une courbe telle que représentée sur la figure 12b.

Sur la figure 12f, le noyau magnétique 102 possède une rainure 125 s'étendant selon un axe 105 parallèle à l'axe 103. La section de la rainure 125 perpendiculairement à l'axe 105 possède une forme en V s'ouvrant vers l'évidement central 106. Ainsi la réluctance du noyau magnétique est plus forte au voisinage de l'évidement central 106 et se réduit en s'éloignant de l'évidement central 106. D'autres formes que la section en V sont bien entendu possibles, par exemple des formes en courbes ou des formes étagées lorsque l'on souhaite des variations discontinue de réluctance en s'éloignant de l'évidement central 106.

Sur la figure 12f, le noyau magnétique 102 possède une rainure 126 s'étendant selon un axe 105 parallèle à l'axe 103. La section de la rainure 126 perpendiculairement à l'axe 105 possède une forme en U. Les branches de U s'étendent selon des directions non radiales par rapport à l'axe 103. Comme pour le noyau représenté sur la figure 12a, la forme de la rainure 126 permet d'augmenter la réluctance par rapport à une rainure de même forme mais orientée radialement comme représenté sur la figure 10.

Comme pour les rainures 93 et 104, il est possible de prévoir plusieurs rainures 120 à 126 dans un même noyau magnétique 102.

La figure 13 représente une architecture électrique 130 mettant en oeuvre un dispositif de filtrage inductif selon l'invention. L'architecture électrique 130 est bien adaptée à équiper un véhicule, notamment un aéronef. L'architecture électrique 130 comprend deux convertisseurs 131 et 132 alimentant une charge 133 à partir d'une source d'énergie électrique 134. L'architecture électrique 130 est reconfigurable en temps réel. Elle permet d'alimenter une charge au moyen d'autant de convertisseurs que nécessaire. La demande de brevet publiée sous le n° EP 2 887 519 et déposée au nom de la demanderesse permet de bien comprendre une façon d'éviter les courants de recirculation dans une architecture où plusieurs convertisseurs sont susceptibles de fonctionner en parallèle. Afin de permettre une reconfiguration aisée de l'architecture électrique, la demande de brevet EP 2 887 519 décrit l'utilisation de dispositifs de filtrage intégrés à chacun des convertisseurs.

La mise en oeuvre de dispositifs de filtrage selon l'invention dans une architecture électrique modulaire comme l'architecture électrique 130 permet, au moyen des mêmes dispositifs de filtrage, à la fois de limiter les courants de recirculation entre les différents convertisseurs connectés en parallèle ainsi que d'assurer la compatibilité électromagnétique de l'architecture électrique 130. Plus précisément, des dispositifs de filtrage selon l'invention permettent de limiter d'éventuels rayonnements émis par l'architecture électrique 130 et susceptibles de perturber d'autres équipements embarqués à bord du véhicule.

Chacun des convertisseurs 131 et 132 reçoit de l'énergie de source d'énergie électrique 134 au travers d'un redresseur 135. Les deux convertisseurs 131 et 132 comprennent, dans l'exemple représenté, des onduleurs 136 délivrant chacun une tension alternative triphasée. Les sorties des deux convertisseurs 131 et 132 sont raccordées pour alimenter la charge 133. D'autres types de convertisseurs, notamment des convertisseurs continu/continu peuvent être mis en oeuvre dans le cadre de l'invention. Les convertisseurs peuvent être monodirectionnels ou bi directionnels.

En entrée, chacun des convertisseurs 131 et 132 comprend un dispositif de filtrage 137 raccordé entre la sortie du redresseur 135 et l'onduleur 136. De même, en sortie, chacun des convertisseurs 131 et 132 comprend un dispositif de filtrage 138 raccordé entre l'onduleur 136 et la charge 133. Les dispositifs de filtrage 137 et 138 comprennent chacun au moins deux noyaux magnétiques toriques tels que décrits précédemment. Les dispositifs de filtrage 137, filtrant la tension continue délivrée par le redresseur 135, comprennent chacun deux conducteurs électriques enroulés ensemble en traversant les évidements centraux de leurs noyaux magnétiques respectifs, un conducteur pour la tension positive et un autre pour la tension négative. Le sens d'enroulement des deux conducteurs est défini de façon à ce que des courants différentiels dans chacun des conducteurs génèrent un flux opposé dans les deux noyaux. De même, les dispositifs de filtrage 138 filtrant la tension de sortie triphasée délivrée par chacun des onduleurs 136, comprennent chacun trois conducteurs électriques enroulés ensemble en traversant les évidements centraux de leurs noyaux magnétiques respectifs, un conducteur pour chacune des phases. En sortie, comme réalisé en entrée, les sens d'enroulement des trois conducteurs est défini de façon à ce que les flux générés par chacun des trois conducteurs s'annulent globalement. L'invention peut être mise en oeuvre quel que soit le nombre de phases en entrée ou en sortie des convertisseurs. Le nombre de conducteurs enroulés ensemble autour des noyaux magnétiques d'un dispositif de filtrage est égal au nombre de phases qu'il est nécessaire de filtrer.

Du fait de leurs noyaux magnétiques commun à plusieurs conducteurs enroulés, un par phase, les dispositifs de filtrage 137 et 138 permettent de filtrer les perturbations de mode commun. En complément, il est possible d'ajouter sur chacune des phases, ici sur les phases de sortie, des dispositifs de filtrage de mode différentiels 140 tels que des inductances raccordées en série sur chacune des phases.

Concernant les dispositifs de filtrage de mode commun 137 et 138, du fait de la présence de plusieurs noyaux magnétiques, chacun d'entre eux peut saturer pour un courant différent circulant dans les deux ou trois conducteurs électriques enroulés. La saturation obtenue pour le courant le plus faible est atteinte pour le noyau ayant la plus petite longueur magnétique et/ou la plus grande perméabilité magnétique. Ce noyau est adapté pour filtrer les perturbations électromagnétiques, généralement à haute fréquence. A la saturation du premier des noyaux magnétiques, le ou les autres noyaux magnétiques du dispositif de filtrage ne saturent pas encore. Ce ou ces autres noyaux sont dimensionnés pour limiter les courants de recirculation entre les différents convertisseurs 131 et 132. Ces courants de recirculation peuvent être très importants, équivalent à un court-circuit au niveau de la sortie du redresseur 135. Dans ce cas, grâce à l'enroulement conjoint des conducteurs au niveau des filtres 137 et/ou 138, et grâce à la présence d'un noyau magnétique à faible perméabilité magnétique relative (inférieure à 3000) qui est dimensionné pour ne pas saturer pour ce courant de court-circuit, le filtre considéré pourra limiter un courant de recirculation entre les deux convertisseurs 131 et 132 le temps de déclencher une autre protection par exemple de type disjoncteur. Durant le filtrage des courants violents tels que les courants de recirculation, les autres noyaux magnétiques auront saturé et ne rempliront plus leur fonction de filtrage. Autrement dit, le filtre selon l'invention assure un filtrage classique de mode commun en l'absence de courants de recirculation et une fonction de secours en mode dégradé, si des courants de recirculation tendent à apparaitre.

Le dispositif de filtrage peut ainsi assurer le filtrage électromagnétique et limiter les courants de recirculation tant que les courants traversant les dispositifs de filtrage restent inférieurs aux courants de saturation de tous les noyaux magnétiques. En cas de disfonctionnement, si les courants traversant les dispositifs de filtrage tendent à augmenter au-delà du courant de saturation le plus faible, bien que le dispositif de filtrage tendent à perdre sa fonction de filtrage électromagnétique, il peut tout de même assurer sa fonction de limitation des courants de recirculation ce qui permet d'éviter des surintensités susceptibles de détruire les composants du convertisseur.

Sur la figure 13, les deux convertisseurs 131 et 132 reçoivent de l'énergie à partir d'un redresseur 135 commun aux deux convertisseurs. Il est également possible de mettre en oeuvre l'invention pour des convertisseurs alternatif/alternatif. Autrement dit, chaque convertisseur comprend son propre redresseur. Dans ce cas, pour chacun des convertisseurs, les dispositifs de filtrage 137 sont disposés entre le redresseur et l'onduleur 136 correspondant. De plus, il est possible de prévoir dans chacun des convertisseurs, en entrée de celui-ci, entre l'alimentation commune via un réseau alternatif et le redresseur de chaque convertisseur, un dispositif de filtrage semblable au dispositif de filtrage 138. Comme pour les convertisseurs 131 et 132, la mise en oeuvre de convertisseurs alternatif/alternatif est très modulaire. Le fait d'intégrer des dispositifs de filtrage conformes à l'invention dans chacun des convertisseurs permet de disposer en parallèle autant de convertisseurs que nécessaire à l'alimentation d'une même charge en évitant la mise en oeuvre de filtrage commun à plusieurs convertisseurs.

**Revendications**

1. Dispositif de filtrage inductif comprenant plusieurs conducteurs électriques (34 ; 47 ; 57 ; 62) groupés dans un même enroulement et destinés chacun à porter une tension électrique différente et au moins deux noyaux magnétiques toriques (12, 22 ; 41, 42, 43, 44 ; 51, 52, 54, 55 ; 82, 84 ; 90 ; 101, 102 ; 111, 112) chacun formé autour d'un évidement central (14, 24 ; 114) les deux noyaux magnétiques ayant des longueurs magnétiques ($L_1$, $L_2$) différentes, les conducteurs électriques étant enroulés ensemble autour des deux noyaux magnétiques en traversant les évidements centraux des deux noyaux magnétiques, l'enroulement étant formé de plusieurs spires, chaque spire de l'enroulement étant réalisée en enroulant simultanément lesdits plusieurs conducteurs électriques (34a, 34b ; 47a, 47b, 47c ; 57a, 57b), dans lequel les noyaux magnétiques toriques (12, 22 ; 41, 42, 43, 44 ; 51, 52, 54, 55 ; 82, 84 ; 90 ; 101, 102 ; 111, 112) sont formés dans des matériaux différents, le matériau du noyau magnétique ayant la plus petite longueur magnétique ($L_1$) possédant une perméabilité magnétique maximum relative inférieure ou égale à 3000 et plus faible que celle du matériau du noyau magnétique ayant la plus grande longueur magnétique ($L_2$).

2. Dispositif de filtrage inductif selon la revendication 1, dans lequel les conducteurs électriques (47a, 47b, 47c) forment ensemble au moins une spire (47-1) enroulée autour des deux noyaux magnétiques (43, 44) et au moins une autre spire (47-2) enroulée autour du noyau magnétique (44) ayant la plus petite longueur magnétique ($L_1$) sans être enroulée autour de l'autre des deux noyaux magnétiques (43).

3. Dispositif de filtrage inductif selon l'une des revendications précédentes, dans lequel chacun des évidements centraux (14, 24) s'étend selon un axe (16, 26), les axes étant confondus.

4. Dispositif de filtrage inductif selon la revendication 2, dans lequel chacun des évidements centraux (14, 24) possède une section vide perpendiculaire à leur axe respectif (16, 26) et dans lequel les sections sont identiques.

5. Dispositif de filtrage inductif selon l'une des revendications 1 à 2, dans lequel un des deux noyaux magnétiques (41, 42, 43, 44 ; 51, 52, 54, 55 ; 101, 102 ; 111, 112) est disposé à l'intérieur de l'évidement central de l'autre noyau magnétique.

6. Dispositif de filtrage inductif selon la revendication 4, dans lequel les deux noyaux magnétiques (111, 112) forment un ensemble monobloc.

7. Dispositif de filtrage inductif selon la revendication 1, comprenant plusieurs séries de noyaux magnétiques toriques (51, 52, 54, 55) insérés les uns dans les autres, les noyaux magnétiques (51, 52) d'une première des séries étant imbriquée autour d'un premier axe (53), les noyaux magnétiques (54, 55) d'une seconde des séries étant imbriquée autour d'un second axe (56), le premier axe (53) étant distinct du second axe (56), dans lequel, le conducteur électrique (57) forme un premier enroulement (58) autour de la première des séries et forme un second enroulement (59) autour de la seconde des séries.

8. Dispositif de filtrage inductif selon l'une des revendications 1 à 3, dans lequel les conducteurs électriques (62) forme enroulement complémentaire (64) réalisé autour des noyaux magnétiques (12) sans traverser leur évidement central.

9. Dispositif de filtrage inductif selon l'une des revendications précédentes, dans lequel, les noyaux magnétiques (12, 22 ; 41, 42, 43, 44 ; 51, 52, 54, 55 ; 82, 84) possèdent des formes tubulaires régulières.

10. Dispositif de filtrage inductif selon l'une 1 à 6, dans lequel, les noyaux magnétiques (90 ; 102 ; 112) possèdent des formes tubulaires irrégulières.

11. Dispositif de filtrage inductif selon la revendication 10, dans lequel, le noyau magnétique (102) ayant la plus petite longueur magnétique ($L_1$) comprend au moins une rainure (104 ; 120 ; 121 ; 122 ; 123, 124 ; 125 ; 126) configurée pour augmenter la réluctance du noyau magnétique considéré (102) sur toute la hauteur de l'évidement central (106), hauteur définie selon un axe (103) autour duquel l'évidement central (106) se développe.

12. Dispositif de filtrage inductif selon la revendication 11, dans lequel, la rainure (122 ; 123, 124) est configurée pour faire varier la réluctance du noyau magnétique considéré (102) selon une abscisse portée par l'axe (103) autour duquel l'évidement central (106) se développe.

13. Dispositif de filtrage inductif selon la revendication 11, dans lequel, la rainure (122 ; 123, 124) est configurée pour faire baisser la réluctance du noyau magnétique considéré (102) en s'éloignant de l'axe (103) autour duquel l'évidement central (106) se développe.

14. Architecture électrique comprenant plusieurs convertisseurs (131, 132) susceptibles d'alimenter en parallèle une charge (133), chacun des convertisseurs comprenant au moins un dispositif de filtrage inductif (137, 138) selon l'une des revendications précédentes.

15. Architecture électrique selon la revendication 14, dans laquelle, les convertisseurs (131, 132) reçoivent de l'énergie sous forme d'un courant continu et délivrent de l'énergie sous forme de courants alternatifs multiphasés,

    • dans laquelle chaque convertisseur comprend, en entrée, un dispositif de filtrage inductif (137) selon l'une des revendications 1 à 13 dans lequel le courant continu circule dans les conducteurs enroulés ensemble,
    • dans laquelle chaque convertisseur comprend, en sortie, un dispositif de filtrage inductif (138) selon l'une des revendications 1 à 13 dans lequel les courants alternatifs circulent dans les conducteurs enroulés ensemble.

**Patentansprüche**

1. Induktive Filtervorrichtung, umfassend mehrere elektrische Leiter (34; 47; 57; 62), die in einer gleichen Wicklung gruppiert sind und jeweils dazu bestimmt sind, eine unterschiedliche elektrische Spannung zu tragen, und mindestens zwei torusförmige Magnetkerne (12, 22; 41, 42, 43, 44; 51, 52, 54, 55; 82, 84; 90; 101, 102; 111, 112), die jeweils um eine zentrale Aussparung (14, 24; 114) herum ausgebildet sind, wobei die beiden Magnetkerne unterschiedliche magnetische Längen ($L_1$, $L_2$) aufweisen, wobei die elektrischen Leiter zusammen um die beiden Magnetkerne gewickelt sind, indem sie durch die zentralen Aussparungen der beiden Magnetkerne hindurchgehen, wobei die Wicklung aus mehreren Windungen gebildet ist, wobei jede Windung der Wicklung durch gleichzeitiges Wickeln der mehreren elektrischen Leiter (34a, 34b; 47a, 47b, 47c; 57a, 57b) hergestellt wird, wobei die torusförmigen Magnetkerne (12, 22; 41, 42, 43, 44; 51, 52, 54, 55; 82, 84; 90; 101, 102 ; 111, 112) aus unterschiedlichen Materialien gebildet sind, wobei das Material des Magnetkerns mit der kürzesten magnetischen Länge ($L_1$) eine relative maximale magnetische Permeabilität von kleiner oder gleich 3 000 aufweist und kleiner ist als die des Materials des Magnetkerns mit der längsten magnetischen Länge ($L_2$).

2. Induktive Filtervorrichtung nach Anspruch 1, wobei die elektrischen Leiter (47a, 47b, 47c) zusammen mindestens eine Windung (47-1) bilden, die um die beiden Magnetkerne (43, 44) gewickelt ist, und mindestens eine weitere Windung (47-2), die um den Magnetkern (44) mit der kleinsten magnetischen Länge ($L_1$) gewickelt ist, ohne um den anderen der beiden Magnetkerne (43) gewickelt zu sein.

3. Induktive Filtervorrichtung nach einem der vorhergehenden Ansprüche, wobei sich jede der zentralen Aussparungen (14, 24) entlang einer Achse (16, 26) erstreckt, wobei die Achsen zusammenfallen.

4. Induktive Filtervorrichtung nach Anspruch 2, wobei jede der zentralen Aussparungen (14, 24) einen leeren Abschnitt senkrecht zu ihrer jeweiligen Achse (16, 26) aufweist und wobei die Abschnitte identisch sind.

5. Induktive Filtervorrichtung nach einem der Ansprüche 1 bis 2, wobei einer der beiden Magnetkerne (41, 42, 43, 44; 51, 52, 54, 55; 101, 102; 111, 112) innerhalb der zentralen Aussparung des anderen Magnetkerns angeordnet ist.

6. Induktive Filtervorrichtung nach Anspruch 4, wobei die beiden Magnetkerne (111, 112) eine einstückige Baugruppe bilden.

7. Induktive Filtervorrichtung nach Anspruch 1, umfassend mehrere Reihen von ineinander eingesetzten torusförmigen Magnetkernen (51, 52, 54, 55), wobei die Magnetkerne (51, 52) einer ersten der Reihen um eine erste Achse (53) verschachtelt sind, die Magnetkerne (54, 55) einer zweiten Achse (56) verschachtelt sind, die Magnetkerne (54, 55) einer zweiten der Reihen um eine zweite Achse (56) verschachtelt sind, wobei sich die erste Achse (53) von der zweiten Achse (56) unterscheidet, wobei der elektrische Leiter (57) eine erste Wicklung (58) um die erste der Reihen bildet und eine zweite Wicklung (59) um die zweite der Reihen bildet.

8. Induktive Filtervorrichtung nach einem der Ansprüche 1 bis 3, wobei die elektrischen Leiter (62) eine komplementäre Wicklung (64) bilden, die um die Magnetkerne (12) hergestellt wird, ohne deren zentrale Aussparung zu durchqueren.

9. Induktive Filtervorrichtung nach einem der vorhergehenden Ansprüche, wobei die Magnetkerne (12, 22; 41, 42, 43, 44; 51, 52, 54, 55; 82, 84) regelmäßige röhrenförmige Formen aufweisen.

10. Induktive Filtervorrichtung nach einem der Ansprüche 1 bis 6, wobei die Magnetkerne (90; 102; 112) unregelmäßige röhrenförmige Formen aufweisen.

11. Induktive Filtervorrichtung nach Anspruch 10, wobei der Magnetkern (102) mit der kleinsten magnetischen Länge ($L_1$) mindestens eine Nut (104; 120; 121; 122; 123, 124; 125; 126) umfasst, die so konfiguriert ist, dass sie die Reluktanz des betrachteten Magnetkerns (102), über die gesamte Höhe der zentralen Aussparung (106), erhöht, wobei die Höhe entlang einer Achse (103) definiert ist, um die sich die zentrale Aussparung (106) herum entwickelt.

12. Induktive Filtervorrichtung nach Anspruch 11, wobei die Nut (122; 123, 124) so konfiguriert ist, dass sie die Reluktanz des betrachteten Magnetkerns (102), entlang einer Abszisse, die von der Achse (103) getragen wird, verändert, um die sich die zentrale Aussparung (106) entwickelt.

13. Induktive Filtervorrichtung nach Anspruch 11, wobei die Nut (122; 123, 124) so konfiguriert ist, dass sie die Reluktanz des betrachteten Magnetkerns (102) senkt, indem sie sich von der Achse (103) entfernt, um die sich die zentrale Aussparung (106) entwickelt.

14. Elektrische Architektur, umfassend mehrere Wandler (131, 132), die geartet sind, eine Last (133) parallel zu speisen, wobei jeder der Wandler mindestens eine induktive Filtervorrichtung (137, 138) nach einem der vorhergehenden Ansprüche umfasst.

15. Elektrische Architektur nach Anspruch 14, wobei die Wandler (131, 132) Energie in Form von Gleichstrom empfangen und Energie in Form von mehrphasigen Wechselströmen abgeben,

> • wobei jeder Wandler am Eingang eine induktive Filtervorrichtung (137) nach einem der Ansprüche 1 bis 13 umfasst, in welcher der Gleichstrom durch die zusammen gewickelten Leiter fließt,
> • wobei jeder Wandler am Ausgang eine induktive Filtervorrichtung (138) nach einem der Ansprüche 1 bis 13 umfasst, in der die Wechselströme in den zusammen gewickelten Leitern fließen.

**Claims**

1. An inductive filtering device comprising multiple electric conductors (34; 47; 57; 62) grouped into the same winding and each intended to support a different electric voltage and at least two toroidal magnetic cores (12, 22; 41, 42, 43, 44; 51, 52, 54, 55; 82, 84; 90; 101, 102; 111, 112), each formed around a central recess (14, 24; 114), the two magnetic cores having different magnetic lengths ($L_1$, $L_2$), the electric conductors being wound together around the two magnetic cores by passing through the central recesses of the two magnetic cores, the winding being formed by multiple turns, each turn of the winding being produced by simultaneously winding said multiple electric conductors (34a, 34b; 47a, 47b, 47c; 57a, 57b), wherein the toroidal magnetic cores (12, 22; 41, 42, 43, 44; 51, 52, 54, 55; 82, 84; 90; 101, 102; 111, 112) are formed from different materials, the material of the magnetic core with the shortest magnetic length ($L_1$) having a relative maximum magnetic permeability that is less than or equal to 3 000 and is lower than that of the material of the magnetic core with the largest magnetic length ($L_2$).

2. The inductive filtering device according to claim 1, wherein the electric conductors (47a, 47b, 47c) together form at least one turn (47-1) wound around the two magnetic cores (43, 44) and at least one other turn (47-2) wound around the magnetic core (44) with the shortest magnetic length ($L_1$) without being wound around the other one of the two magnetic cores (43).

3. The inductive filtering device according to any of the preceding claims, wherein each of the central recesses (14, 24) extends along an axis (16, 26), with the axes being coincident.

4. The inductive filtering device according to claim 2, wherein each of the central recesses (14, 24) has a void section perpendicular to their respective axis (16, 26) and wherein the sections are identical.

5. The inductive filtering device according to any of claims 1 to 2, wherein one of the two magnetic cores (41, 42, 43, 44; 51, 52, 54, 55; 101, 102; 111, 112) is disposed inside the central recess of the other magnetic core.

6. The inductive filtering device according to claim 4, wherein the two magnetic cores (111, 112) form a one-piece assembly.

7. The inductive filtering device according to claim 1, comprising multiple series of toroidal magnetic cores (51, 52, 54, 55) inserted into one another, the magnetic cores (51, 52) of a first one of the series being nested around a first axis (53), the magnetic cores (54, 55) of a second one of the series being nested around a second axis (56), the first axis (53) being distinct from the second axis (56), wherein the electric conductor (57) forms a first winding (58) around the first one of the series and forms a second winding (59) around the second one of the series.

8. The inductive filtering device according to any of claims 1 to 3, wherein the electric conductors (62) form a complementary winding (64) produced around the magnetic cores (12) without passing through their central recess.

9. The inductive filtering device according to any of the preceding claims, wherein the magnetic cores (12, 22; 41, 42, 43, 44; 51, 52, 54, 55; 82, 84) have regular tubular shapes.

10. The inductive filtering device according to any of claims 1 to 6, wherein the magnetic cores (90; 102; 112) have irregular tubular shapes.

11. The inductive filtering device according to claim 10, wherein the magnetic core (102) with the shortest magnetic length ($L_1$) comprises at least one groove (104; 120; 121; 122; 123, 124; 125; 126) configured to increase the reluctance of the considered magnetic core (102) over the entire height of the central recess (106), the height being defined along an axis (103) around which the central recess (106) is established.

12. The inductive filtering device according to claim 11, wherein the groove (122; 123, 124) is configured to vary the reluctance of the considered magnetic core (102) along an abscissa borne by the axis (103) around which the central recess (106) is established.

13. The inductive filtering device according to claim 11, wherein the groove (122; 123, 124) is configured to decrease the reluctance of the considered magnetic core (102) by moving away from the axis (103) around which the central recess (106) is established.

14. An electric architecture comprising multiple converters (131, 132) capable of supplying a load (133) in parallel, each of the converters comprising at least one inductive filtering device (137, 138) according to any of the preceding claims.

15. The electric architecture according to claim 14, wherein the converters (131, 132) receive energy in the form of a direct current and deliver energy in the form of multiphase alternating currents,

> • wherein each converter comprises, at the input, an inductive filtering device (137) according to any of claims 1 to 13 in which the direct current circulates in the conductors that are wound together;
> • wherein each converter comprises, at the output, an inductive filtering device (138) according to any of claims 1 to 13 in which the alternating currents circulate in the conductors that are wound together.

*Fig. 1a*

*Fig. 1b*

*Fig. 2*

*Fig. 3*

*Fig. 4*

*Fig. 5*

Fig. 6

Fig. 7

Fig. 8

Fig. 9

*Fig. 10*

*Fig. 11*

Fig. 12a

Fig. 12b

Fig. 12c

Fig. 12d

Fig. 12e

Fig. 12f

Fig. 12g

*Fig. 13*

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2007113312 A

- EP 2887519 A